# EUROPÄISCHE PATENTSCHRIFT

(11) **EP 0 951 741 B1**
(45) Veröffentlichungstag und Bekanntmachung des Hinweises auf die Patenterteilung: **12.01.2005**
(21) Anmeldenummer: 97935459.4
(22) Anmeldetag: 22.07.1997
(51) Int. Cl.: H01L 41/04

(54) **VORRICHTUNG UND VERFAHREN ZUM ANSTEUERN WENIGSTENS EINES KAPAZITIVEN STELLGLIEDES**
DEVICE AND PROCESS FOR CONTROLLING AT LEAST ONE CAPACITATIVE ACTUATOR
DISPOSITIF ET PROCEDE POUR LA COMMANDE D'AU MOINS UN ACTIONNEUR CAPACITIF

(30) Priorität: 14.08.1996 DE 19632871
(43) Veröffentlichungstag der Anmeldung: 27.10.1999
(73) Patentinhaber: SIEMENS AKTIENGESELLSCHAFT, 80333 München (DE)
(72) Erfinder: HOFFMANN, Christian, D-93057 Regensburg (DE); FREUDENBERG, Hellmut, D-93080 Grossberg (DE); GERKEN, Hartmut, D-93152 Nittendorf (DE); HECKER, Martin, D-93336 Laimerstadt (DE); PIRKL, Richard, D-93053 Regensburg (DE)
(86) Internationale Anmeldenummer: PCT/DE1997/001547
(87) Internationale Veröffentlichungsnummer: WO 1998/007198

(56) Entgegenhaltungen:
- US-A- 5 130 598

## Beschreibung

Die Erfindung betrifft eine Vorrichtung zum Ansteuern wenigstens eines kapazitiven Stellgliedes (P1 bis Pn) mittels einer Steuerschaltung (ST), insbesondere eines piezoelektrisch betriebenen Kraftstoffeinspritzventils einer Brennkraftmaschine gemäß den Merkmalen des Patentanspruchs 1. Die Erfindung betrifft auch ein Verfahren zum Betreiben diser Vorrichtung.

Aus EP 0 464 443 A1 ist ein Piezo-Stellglied bekannt, welches aus einem Kondensator über eine Ladespule geladen wird. Ein Teil der aufgebrachten Energie wird beim Entladen des Piezo-Stellgliedes über eine Entladespule in den Kondensator zurückgespeist, während der andere Teil, ebenfalls über die Entladespule, durch Kurzschließen vernichtet wird. Beim Entladen liegt am Piezo-Stellglied eine negative Spannung.

Aus DE 36 21 541 C2 ist eine Treiberschaltung für ein Piezostellglied eines Kraftstoffeinspritzventils bekannt, welches über eine an einer Spannungsquelle liegende Reihenschaltung zweier Kondensatoren und eine Ladespule geladen und über eine Entladespule in einen der beiden Kondensatoren entladen wird. Bei einer alternativen Ausführung wird das Stellglied über einen an einer Spannungsquelle liegenden Kondensator und eine Ladespule geladen; beim Entladen wird die im Piezostellglied gespeicherten Energie über eine Entladespule vernichtet.

Der Erfindung liegt die Aufgabe zugrunde, eine möglichst verlustarm arbeitende und einfach aufgebaute Vorrichtung und ein Verfahren zum Ansteuern wenigstens eines kapazitiven Stellgliedes zu schaffen, bei welcher das Stellglied wieder voll entladen wird und negative Spannungen an ihm vermieden werden.

Diese Aufgabe wird erfindungsgemäß durch die Merkmale des Patentanspruchs 1 gelöst. Vorteilhafte Ausgestaltungen der Erfindung sind den Unteransprüchen zu entnehmen.

Von Vorteil ist insbesondere, daß die Spannungsquelle nur für die halbe Ladespannung ausgelegt werden muß, und daß auch bei großer Streuung der Stellglied-Kapazitäten eine vollständige Entladung erfolgt, da jedes Stellglied in die parallelgeschalteten Kondensatoren C1 und C2 entladen wird, deren Kapazität etwa viermal so groß wie die Stellgliedkapazität gewählt sein kann. Das Laden und Entladen jedes Stellgliedes erfolgt mit einer kompletten Sinushalbschwingung des Stromes. Dadurch erreicht das Stellglied seine Betriebsspannung und damit seinen Endhub mit "langsamer" Geschwindigkeit (im Maximalwert einer Cosinusschwingung). Es entstehen im Frequenzspektrum nur Frequenzen unterhalb einer Grundfrequenz von - beim Betrieb eines piezoelektrisch betriebenen Kraftstoffeinspritzventils - maximal 300Hz, wodurch kaum EMV-Probleme entstehen. Außerdem kann die Umschwingspule aus einem für die Schaltung vorgesehenen Gehäuse näher zu den Stellgliedern verlagert werden, da zwischen ihr und den Stellgliedern kein Schalter angeordnet ist.

Ein Ausführungsbeispiel der Erfindung ist im folgenden unter Bezugnahme auf die schematische Zeichnung näher erläutert. Es zeigen:
Figur 1: die Schaltung eines Ausführungsbeispiels, und
Figur 2: ein Flußdiagramm, seine Arbeitsweise betreffend.

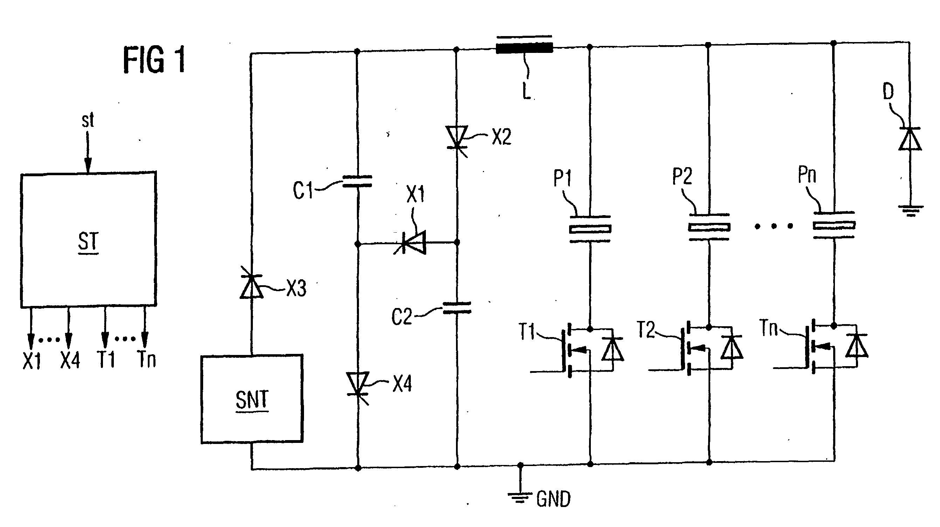

Figur 1 zeigt die Schaltung eines Ausführungsbeispiels nach der Erfindung zum Ansteuern von weiter nicht dargestellten Kraftstoffeinspritzventilen einer Brennkraftmaschine über piezoelektrische Stellglieder P1 bis Pn mittels einer Steuerschaltung ST, die Teil eines weiter nicht dargestellten mikroprozessor-gesteuerten Motorsteuergerätes ist.

Zwischen dem Pluspol +SNT und dem Minuspol GND einer Spannungsquelle SNT ist eine Reihenschaltung aus einem Nachladeschalter X3, einem ersten Entladeschalter X2, einem Ladeschalter X1 und einem zweiten Entladeschalter X4 angeordnet. Die Schalter X1 bis X4 sind in Richtung zum Minuspol GND hin stromdurchlässig.

Wenn von den Schaltern X1 bis X4 die Rede ist, handelt es sich um elektronische, nur in einer Richtung stromdurchlässige, aus wenigstens einem Halbleiterelement bestehende Schalter, vorzugsweise Thyristorschalter, die von der Steuerschaltung leitend gesteuert werden.

Parallel zur Reihenschaltung aus dem ersten Entladeschalter X2 und dem Ladeschalter X1 ist ein erster Kondensator C1 angeordnet, und parallel zur Reihenschaltung aus dem Ladeschalter X1 und dem zweiten Entladeschalter X4 ist ein zweiter Kondensator (C2) angeordnet.

Vom Verbindungspunkt des Nachladeschalters X3 und des ersten Entladeschalters X2 führt eine Reihenschaltung aus einer Umschwingspule L, einem ersten Stellglied P1 und einem ersten, gesteuerten Power-MOSFET-Schalter T1 zum Masseanschluß GND.

Für jedes weitere Stellglied ist eine der Reihenschaltung des ersten Stellgliedes P1 und des ersten Power-MOSFET-Schalters T1 parallel geschaltete Reihenschaltung aus diesem Stellglied P2 bis Pn und einem weiteren Power-MOSFET-Schalter T2 bis Tn vorgesehen. Parallel zu allen Reihenschaltungen aus Stellglied und Power-MOSFET-Schalter ist eine vom Masseanschluß GND zur Umschwingspule L hin stromdurchlässige Diode D angeordnet.

Power-MOSFET-Schalter enthalten üblicherweise Inversdioden, deren Funktion, wie weiter unten näher erläutert, beim Betrieb der erfindungsgemäßen Vorrichtung benutzt wird. Die Schalter X1 bis X4 und T1 bis Tn werden von der Steuerschaltung ST, abhängig von Steuersignalen st des Motorsteuergerätes gesteuert.

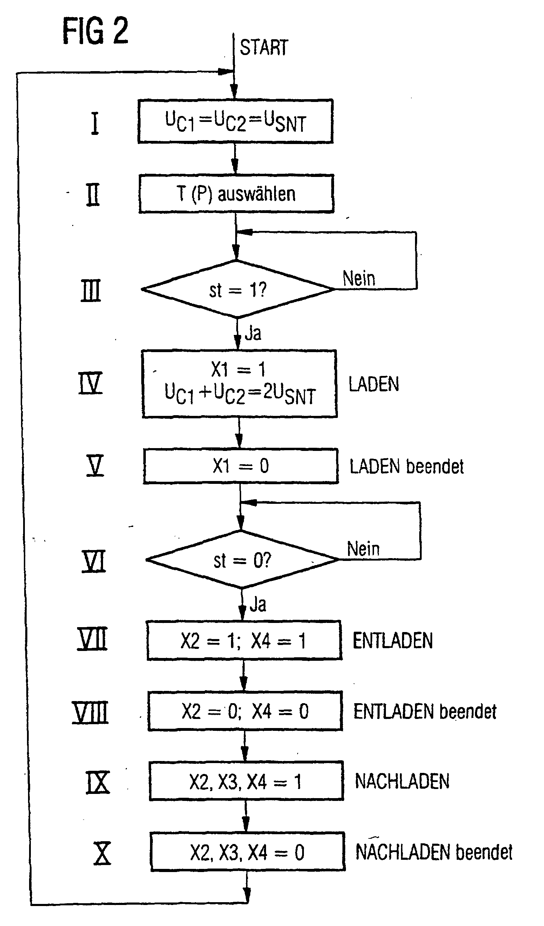

Ein Verfahren zum Betreiben der beschriebenen Vorrichtung wird nachstehend anhand der Figur 2 näher erläutert. Auf die Kästen I bis X der Figur 2 wird im folgenden Text nur durch römische Zahlen hingewiesen.

Ausgehend von einem Zustand, in welchem jeder der beiden Kondensatoren C1 und C2 auf die Ausgangsspannung U_{SNT} der Spannungsquelle SNT aufgeladen ist, die Umschwingspule L stromlos ist, alle Schalter X1 bis X4 und T1 bis Tn nichtleitend (hochohmig) und alle Stellglieder P1 bis Pn entladen sind (I), soll das Stellglied P1 betätigt werden, um über das zugeordnete Einspritzventil Kraftstoff in einen Zylinder einzuspritzen.

Zunächst wählt die Steuerschaltung das entsprechende Stellglied aus (II), indem sie den ihm zugeordneten Power-MOSFET-Schalter T1 zumindest für die Dauer eines Ladevorgangs leitend steuert. T1 kann aber auch über einen Kurbelwellenwinkel KW = 720°KW/Z (Z = Zahl der Zylinder) leitend (niederohmig) bleiben, das sind beispielsweise bei Vierzylindermotoren 180°KW und bei Sechszylindermotoren 120°KW.

Bei Einspritzbeginn, der durch den Beginn eines Steuersignals st vorgegeben wird (III), wird von der Steuerschaltung ST der Ladeschalter X1 gezündet (IV), wodurch die beiden Kondensatoren C1 und C2 in Reihe geschaltet werden. Dadurch entlädt sich die an C1 + C2 liegende Spannung U_{C1+C2} = 2*U_{SNT} während einer kompletten Sinushalbschwingung über die Umschwingspule L in das Stellglied P1 und dieses öffnet das nicht dargestellte Einspritzventil.

Nach dem Umschwingen verlischt der Ladeschalter X1 (V), das stellglied P1 bleibt geladen. An den Kondensatoren C1 und C2 verbleibt eine von der Kapazität abhängige Restspannung.

Zum Entladen des Stellgliedes am Ende eines Steuersignals st (VI) werden die beiden Entladeschalter X2 und X4 gezündet (VII). Dadurch entsteht für die beiden Kondensatoren C1 und C2 eine Parallelschaltung, in welche das Stellglied P1 entladen wird. Der Entladestromkreis schließt sich über die Inversdiode des Power-MOSFET-Schalters T1. Die im Stellglied P1 gespeicherte Energie schwingt über die Umschwingspule L in die beiden parallelgeschalteten Kondensatoren C1 und C2 zurück, die infolge der entstehenden Verluste auf eine Spannung U < U_{SNT} geladen werden, und kann für den folgenden Zyklus genutzt werden. Durch die Parallelschaltung von C1 und C2 (Vergrößerung der Kapazität) beim Entladen des Stellgliedes wird dieses trotz der verbliebenen Restspannung (von-beispielsweise +10V) sicher entladen.

Sobald das Stellglied auf die Schwellspannung der parallel liegenden Diode D entladen ist, setzt sich der noch fließende Strom über diese Diode fort,wodurch ein Aufladen des Stellgliedes auf eine negative Spannung verhindert wird. Anschließend verlöschen die beiden Entladeschalter X2 und X4 (VIII).

Für den Ladezyklus des nächsten Stellgliedes müssen zunächst die entstandenen Verluste ausgeglichen werden. Dazu werden die beiden Entladeschalter X2 und X4 wieder und zusätzlich der Nachladeschalter X3 gezündet, wodurch die nun wieder parallel zueinander liegenden Kondensatoren C1 und C2 auf die Ausgangsspannung U_{SNT} der Spannungsquelle SNT aufgeladen werden. Anschließend verlöschen die Schalter X2, X3 und X4 und es kann das nächste Stellglied ausgewählt werden und sich das Verfahren für dieses Stellglied von Anfang an wiederholen u.s.w.

## Patentansprüche

1. Vorrichtung zum Ansteuern wenigstens eines kapazitiven Stellgliedes (P1 bis Pn) mittels einer Steuerschaltung (ST), insbesondere eines piezoelektrisch betriebenen Kraftstoffeinspritzventils einer Brennkraftmaschine,
- mit einer zwischen Pluspol (+SNT) und Minuspol (GND) einer Spannungsquelle (SNT) angeordneten, zum Minuspol (GND) hin stromdurchlässigen Reihenschaltung aus einem Nachladeschalter (X3), einem ersten Entladeschalter (X2), einem Ladeschalter (X1) und einem zweiten Entladeschalter (X4),
- mit einem parallel zur Reihenschaltung aus erstem Entladeschalter (X2) und Ladeschalter (X1) angeordneten ersten Kondensator (C1),
- mit einem parallel zur Reihenschaltung aus Ladeschalter (X1) und zweitem Entladeschalter (X4) angeordneten zweiten Kondensator (C2),
- mit einer zwischen dem Verbindungspunkt des Nachladeschalters (X3) und des ersten Entladeschalters (X2) und dem Masseanschluß (GND) liegenden Reihenschaltung aus einer Umschwingspule (L), einem ersten Stellglied (P1) und einem ersten, gesteuerten Power-MOSFET-Schalter(T1),
- mit einer der Reihenschaltung des ersten Stellgliedes (P1) und des ersten Power-MOSFET-Schalters (T1) parallel geschalteten, für jedes weitere Stellglied vorgesehenen Reihenschaltung aus diesem Stellglied (P2 bis Pn) und einem weiteren Power-MOSFET-Schalter (T2 bis Tn), und
- mit einer parallel zu allen Reihenschaltungen aus Stellglied und Power-MOSFET-Schalter angeordneten, vom Masseanschluß (GND) zur Umschwingspule (L) hin stromdurchlässigen Diode (D).

2. Vorrichtung nach Anspruch 1, **dadurch gekennzeichnet, daß** die Steuerschaltung (ST) ein Teil eines mi'kroprozessor-gesteuerten Motorsteuergerätes ist.

3. Vorrichtung nach Anspruch 1, **dadurch gekennzeichnet, daß** Ladeschalter (X1), Entladeschalter (X2, X4) und Nachladeschalter (X3) gesteuerte, elektronische, nur in einer Richtung stromdurchlässige Schalter mit wenigstens einem Halbleiterelement sind.

4. Verfahren zum Betreiben der Vorrichtung nach Anspruch 1, **dadurch gekennzeichnet,**
- **daß** die beiden Kondensatoren (C1 , C2) in Parallelschaltung auf die Ausgangsspannung (Us) der Spannungsquelle (SNT) aufgeladen werden,
- **daß** das jeweils anzusteuernde Stellglied (P1 bis Pn) über die Umschwingspule (L) aus den in Reihe geschalteten, geladenen Kondensatoren (C1, C2) geladen wird,
- **daß** das jeweils angesteuerte Stellglied (P1 bis Pn) über die Umschwingspule (L) in die beiden parallelgeschalteten Kondensatoren (C1, C2) entladen wird, und
**daß** anschließend die beiden parallelgeschalteten Kondensatoren (C1 , C2) auf die Ausgangsspannung (Us) der Spannungsquelle (SNT) nachgeladen werden.

## Claims

1. Device for controlling at least one capacitive actuator (P1 to Pn) by means of a control circuit (ST), in particular a piezoelectrically operated fuel injection valve in an internal combustion engine,
- with a series circuit comprising a re-charge switch (X3), a first discharge switch (X2), a charge switch (X1) and a second discharge switch (X4) arranged between the positive pole (+SNT) and negative pole (GND) of a voltage source (SNT) and allowing current to pass in the direction of the negative pole (GND),
- with a first capacitor (C1) arranged parallel to the series circuit comprising the first discharge switch (X2) and the charge switch (X1),
- with a second capacitor (C2) arranged parallel to the series circuit comprising the charge switch (X1) and the second discharge switch (X4),
- with a series circuit comprising a reversal coil (L), a first actuator (P1) and a first, controlled power MOSFET switch (T1) arranged between the connection point of the re-charge switch (X3) and the first discharge switch (X2) and the earth terminal (GND),
- with a series circuit comprising the actuator (P2 to Pn) and a further power MOSFET switch (T2 to Tn) provided for each further actuator and connected parallel to the series circuit of the first actuator (P1) and the first power MOSFET switch (T1), and
- with a diode (D) that allows current to pass from the earth terminal (GND) to the reversal coil (L) arranged parallel to all series circuits comprising an actuator and a power MOSFET switch.

2. Device according to Claim 1,
**characterized in that** the control circuit (ST) is part of a microprocessor-controlled engine control device.

3. Device according to Claim 1,
**characterized in that** the charge switch (X1), discharge switches (X2, X4) and re-charge switch (X3) are controlled, electronic switches that allow current to pass in only one direction and have at least one semiconductor element.

4. Method for operating the device according to Claim 1,
**characterized in that**
- the two capacitors (C1, C2) are charged in a parallel circuit to the output voltage (Uₛ) of the voltage source (SNT),
- the controlling actuator (P1 to Pn) in each instance is charged via the reversal coil (L) from the series-connected, charged capacitors (C1, C2),
- the controlled actuator (P1 to Pn) in each instance is discharged via the reversal coil (L) to the two parallel-connected capacitors (C1, C2), and
the two parallel-connected capacitors (C1, C2) are then re-charged to the output voltage (Uₛ) of the voltage source (SNT).

## Revendications

1. Dispositif pour la commande d'au moins un actionneur capacitif (P1 à Pn) à l'aide d'un circuit de commande (ST), en particulier d'une soupape d'injection de carburant d'un moteur à combustion interne actionnée piézo-électriquement, comprenant :
- un couplage en série placé entre le pôle positif (+SNT) et le pôle négatif (GND) d'une source de tension (SNT), à l'état passant en direction du pôle négatif (GND) constitué d'un commutateur de recharge (X3), d'un premier commutateur de décharge (X2), d'un commutateur de charge (X1) et d'un second commutateur de décharge (X4),
- un premier condensateur (C1) placé parallèlement au couplage en série constitué d'un premier commutateur de décharge (X2) et d'un commutateur de charge (X1),
- un second condensateur (C2) placé parallèlement au couplage en série constitué d'un commutateur de charge (X1) et d'un second commutateur de décharge (X4),
- un couplage en série se trouvant entre le point de raccordement du commutateur de recharge (X3) et du premier commutateur de décharge (X2) et la connexion à la masse (GND) constitué d'une bobine oscillante (L), d'un premier actionneur (P1 ) et d'un premier commutateur Power-MOSFET (T1 ) commandé,
- un couplage en série couplé en parallèle au couplage en série du premier actionneur (P1) et du premier commutateur Power-MOSFET (T1), prévu pour chaque autre actionneur constitué de cet actionneur (P2 à Pn) et d'un autre commutateur Power-MOSFET (T2 à Tn), et
- une diode (D) placée parallèlement à tous les couplages en série constitués d'un actionneur et d'un commutateur Power-MOSFET (T1), à l'état passant entre la connexion à la masse (GND) et la bobine oscillante (L).

2. Dispositif selon la revendication 1, **caractérisé en ce que** le circuit de commande (ST) fait partie d'un appareil de commande de moteur commandé par microprocesseur.

3. Dispositif selon la revendication 1, **caractérisé en ce que** le commutateur de charge (X1), les commutateurs de décharge (X2, X4) et le commutateur de recharge (X3) sont des commutateurs commandés, électroniques, à l'état passant dans un sens seulement, avec au moins un élément à semi-conducteurs.

4. Procédé pour l'actionnement du dispositif selon la revendication 1, **caractérisé en ce que**,
- les deux condensateurs (C1, C2) couplés en parallèle sont chargés à la tension de sortie (Us) de la source de tension (SNT),
- l'actionneur (P1 à Pn) à commander respectivement est chargé par la bobine oscillante (L) à partir des condensateurs (C1, C2) chargés, couplés en série,
- l'actionneur (P1 à Pn) à commander respectivement est déchargé par la bobine oscillante (L) dans les deux condensateurs couplés en parallèle (C1, C2), et
**en ce que**, ensuite, les deux condensateurs couplés en parallèle (C1, C2) sont rechargés à la tension de sortie (Us) de la source de tension (SNT).
